# EUROPEAN PATENT SPECIFICATION

(11) **EP 0 401 113 B1**
(45) Date of publication and mention of the grant of the patent: **24.07.1996**
(21) Application number: 90401446.1
(22) Date of filing: 30.05.1990
(51) Int. Cl.: H01L 21/82, H01L 27/108, H01L 21/336, H01L 21/28

(54) **Semiconductor device and production method thereof**
Halbleiteranordnung und Verfahren zu deren Herstellung
Dispositif semi-conducteur et son procédé de fabrication

(30) Priority: 31.05.1989 JP 137861/89
(43) Date of publication of application: 05.12.1990
(73) Proprietor: FUJITSU LIMITED, Kawasaki-shi, Kanagawa 211 (JP)
(72) Inventor: Ema, Taiji, Kawasaki-shi, Kanagawa 213 (JP)
(74) Representative: Joly, Jean-Jacques

(56) References cited:
- EP-A- 0 191 612
- EP-A- 0 218 408
- EP-A- 0 258 657
- EP-A- 0 263 941
- EP-A- 0 317 160

## Description

### BACKGROUND OF THE INVENTION

The present invention generally relates to semiconductor devices and production methods thereof, and more particularly to a semiconductor device having first and second transistors and a production method thereof, where there are three demands on the first and second transistors. First, there is a demand to suppress generation of crystal defect in the first transistor by not subjecting an impurity diffusion layer of the first transistor to an etching. Second, there is a demand to form a conductor layer on the first transistor via an insulator layer. Third, there is a demand to obtain a satisfactory current driving capability for the second transistor.

For example, in a dynamic random access memory (DRAM) which is provided with stacked capacitors, there are demands to simultaneously satisfy three conditions in order to improve the charge storage characteristic of memory cells. A first condition is not to subject an impurity diffusion layer of a transistor which makes up the memory cell so as to suppress the generation of crystal defect. A second condition is to facilitate the formation of a storage electrode by flattening a layer below the storage electrode. A third condition is to ensure a satisfactory current driving capability of the transistor of a peripheral circuit.

Reference is made to EP-A-0 191 612 disclosing a DRAM device.

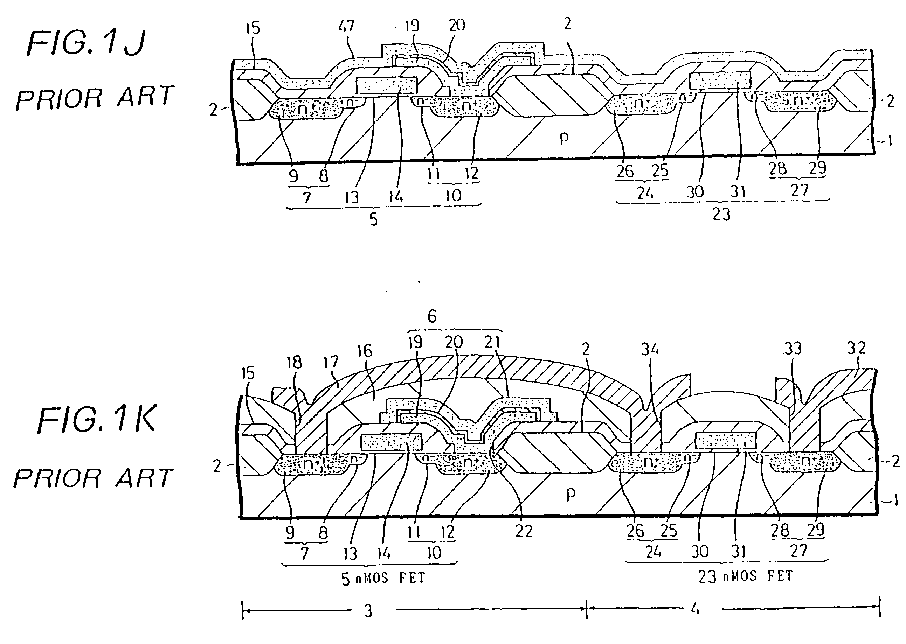

Conventionally, there is a DRAM provided with stacked capacitors as shown in FIG.1K which shows a cross section of an essential part of this conventional DRAM. The DRAM includes a p-type silicon (Si) substrate 1, a field oxide layer 2 which forms a device isolation region, a memory cell 3, and a peripheral circuit 4.

The memory cell 3 is made up of an n-channel insulated-gate type field effect transistor (hereinafter simply referred to as an nMOS FET) 5 which forms a transistor for controlling input/output of charge, and a stacked capacitor 6. The nMOS FET 5 has a lightly doped drain (LDD) structure. A source diffusion layer 7 of the nMOS FET 5 is made up of an n⁻-type source diffusion layer 8 and an n⁺-type source diffusion layer 9. A drain diffusion layer 10 of the nMOS FET 5 is made up of an n⁻-type drain diffusion layer 11 and an n⁺-type drain diffusion layer 12.

A gate insulator layer 13 is made of silicon dioxide (SiO₂), a gate electrode (word line) 14 is made of polysilicon, an interlayer insulator 15 is made of SiO₂, an interlayer insulator 16 is made of phospho-silicate glass (PSG), and a bit line 17 is made of aluminum (Al). The bit line 17 makes an ohmic contact with the n⁺-type source diffusion layer 9 via a contact hole 18.

The stacked capacitor 6 is made up of a stacked structure including a polysilicon storage electrode 19, a SiO₂ capacitor insulator layer 20 and a polysilicon confronting electrode 21. The storage electrode 19 makes an ohmic contact with the n⁺-type drain diffusion layer 12 via a contact hole 22.

The peripheral circuit 4 is made up of an nMOS FET 23 which also has the LDD structure. A source diffusion layer 24 of the nMOS FET 23 is made up of an n⁻-type source diffusion layer 25 and an n⁺-type source diffusion layer 26. On the other hand, a drain diffusion layer 27 of the nMOS FET 23 is made up of an n⁻-type drain diffusion layer 28 and an n⁺-type drain diffusion layer 29.

A gate insulator layer 30 is made of SiO₂, a gate electrode 31 is made of polysilicon, and an interconnection 32 is made of Al. The interconnection 32 makes an ohmic contact with the n⁺-type drain diffusion layer 29 via a contact hole 33.

In addition, the bit line 17 makes an ohmic contact with the n⁺-type source diffusion layer 26 via a contact hole 34.

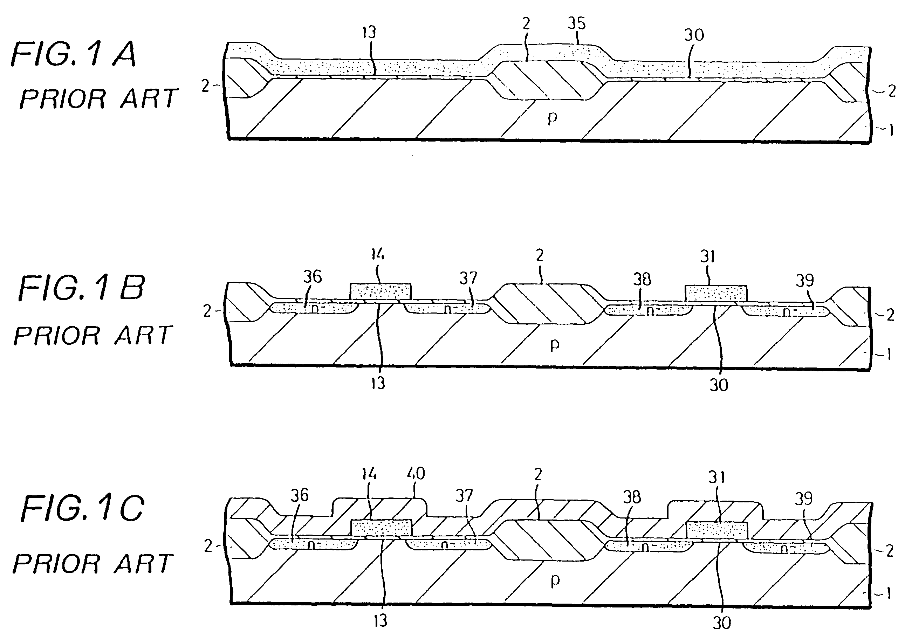

This conventional DRAM is produced in a sequence shown in FIGS.1A through 1K.

First, the p-type Si substrate 1 is prepared as shown in FIG.1A. A surface of this p-type Si substrate 1 is selectively oxidized to form the field oxide layer 2 which has a thickness of 5000 Å, 1Å = 10⁻¹⁰ m for example. Then, the SiO₂ layers 13 and 30 are formed in a device region by a thermal oxidation to a thickness of 150 Å, for example. Furthermore, a polysilicon layer 35 having a thickness of 2000 Å, for example, is formed on the entire surface of the stacked structure by a chemical vapor deposition (CVD).

Next, the polysilicon layer 35 is patterned, and as shown in FIG.1B, the gate electrodes 14 and 31 are formed. Then, the gate electrodes 14 and 31 and the field oxide layer 2 are used as a mask when implanting phosphorous (P) ions into the p-type Si substrate 1 with an energy of 50 keV and a dosage of 1 x 10¹³ cm⁻², for example. As a result, n⁻-type diffusion layers 36-39 are formed.

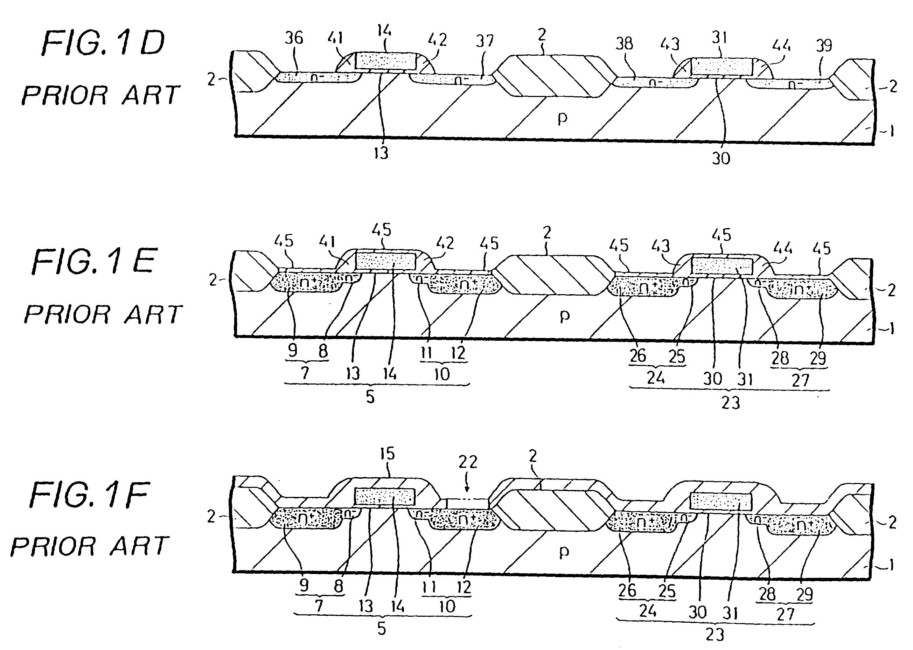

Thereafter, as shown in FIG.1C, a SiO₂ layer 40 having a thickness of 3000 Å, for example, is formed on the entire surface of the stacked structure by a CVD. A reactive ion etching (RIE) is made with respect to the SiO₂ layer 40 and the SiO₂ layers 13 and 30 under the SiO₂ layer 40, so as to partially expose the n⁻-type diffusion layers 36, 37, 38 and 39 as shown in FIG.1D. In this state, so-called side wall SiO₂ layers 41, 42, 43 and 44 are formed on the side wall portions of the gate electrodes 14 and 31.

Next, a thermal oxidation is made to form a SiO₂ layer 45 which has a thickness of 150 Å, for example, on the exposed surfaces of the p-type Si substrate 1 and the gate electrodes 14 and 31 as shown in FIG.1E. Thereafter, the gate electrodes 14 and 31, the side wall SiO₂ layers 41, 42, 43 and 44 and the field oxide layer 2 are used as a mask when implanting arsenic (As) ions into the p-type Si substrate 1 with an energy of of 50 keV and a dosage of 4 x 10¹⁵ cm⁻², for example. As a result, the nMOS FET 5 and the nMOS FET 23 are formed. The nMOS FET 5 has the source diffusion layer 7 which is made up of the n⁻-type source diffusion layer 8 and the n⁺-type source diffusion layer 9, and the drain diffusion layer 10 which is made up of the n⁻-type drain diffusion layer 11 and the n⁺-type drain diffusion layer 12. Similarly, the nMOS FET 23 has the source diffusion layer 24 which is made up of the n⁻-type source diffusion layer 25 and the n⁺-type source diffusion layer 26, and the drain diffusion layer 27 which is made up of the n⁻-type drain diffusion layer 28 and the n⁺-type drain diffusion layer 29.

Then, as shown in FIG.1F, a SiO₂ layer having a thickness of 1000 Å, for example, is formed on the entire surface of the stacked structure by a CVD so as to form the interlayer insulator 15 which is made of SiO₂. The contact hole 22 which has a width of 0.8 µm, for example, is formed in the interlayer insulator 15 above the n⁺-type drain diffusion layer 12.

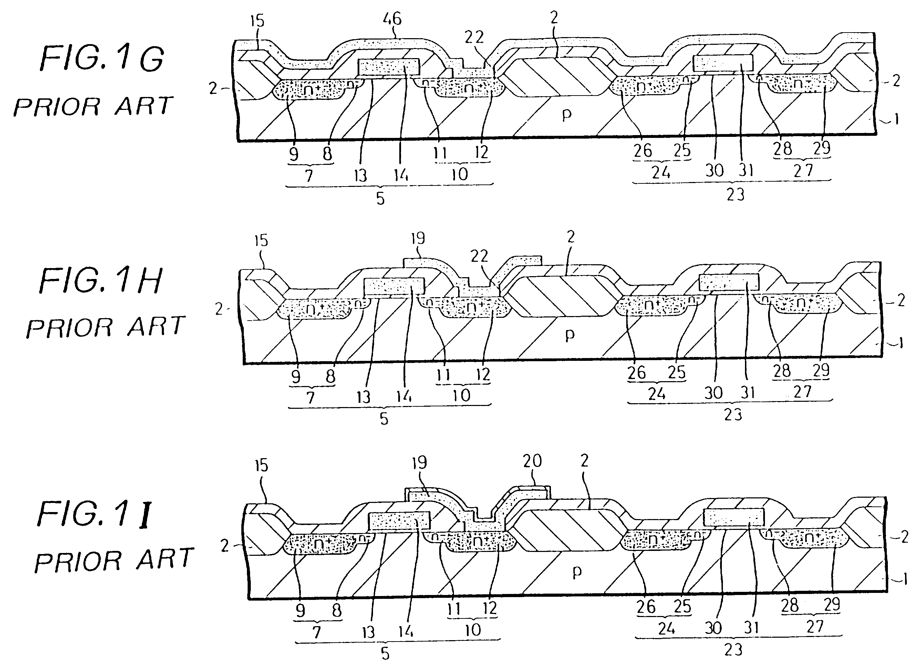

Next, as shown in FIG.1G, a polysilicon layer 46 having a thickness of 2000 Å, for example, is formed on the entire surface of the stacked structure. As ions are implanted into this polysilicon layer 46 with an energy of 50 keV and a dosage of 1 x 10¹⁵ cm⁻², for example, so as to reduce the resistance. The polysilicon layer 46 is then patterned as shown in FIG.1H, and the storage electrode 19 which makes an ohmic contact with the n⁺-type drain diffusion layer 12 via the contact hole 22 is formed.

Thereafter, an oxide layer which is naturally formed on the exposed surface of the storage electrode 19 is removed by an etching using a hydrogen fluoride (HF) solution. Further, a thermal oxidation is carried out to form a SiO₂ capacitor insulator layer 20 which has a thickness of 100 Å, for example, on the exposed surface of the storage electrode 19 as shown in FIG.1I.

Next, a polysilicon layer 47 having a thickness of 2000 Å, for example, is formed on the entire surface of the stacked structure as shown in FIG.1J, and P is thermally diffused into the polysilicon layer 47 to reduce the resistance. Thereafter, this polysilicon layer 47 is patterned to form the confronting electrode 21 as shown in FIG.1K.

Then, the PSG layer 16 is formed on the entire surface of the stacked structure to a thickness of 5000 Å, for example, as shown in FIG.1K. The contact holes 18, 33 and 34 are formed in the PSG layer 16, and the bit line 17 and the other interconnection 32 are formed. As a result, the conventional DRAM having the stacked capacitor 6 is obtained.

According to the conventional method of producing the DRAM shown in FIG.1K, the side wall SiO₂ layers 41 and 42 are formed on the side wall portions of the gate electrode 14 as shown in FIG.1D in order to realize the LDD structure of the nMOS FETs 5 and 23. The side wall SiO₂ layers 41 and 42 flatten the vertical stepped portions at the side wall portions of the gate electrode 14, and have a function of facilitating the formation of the storage electrode 19.

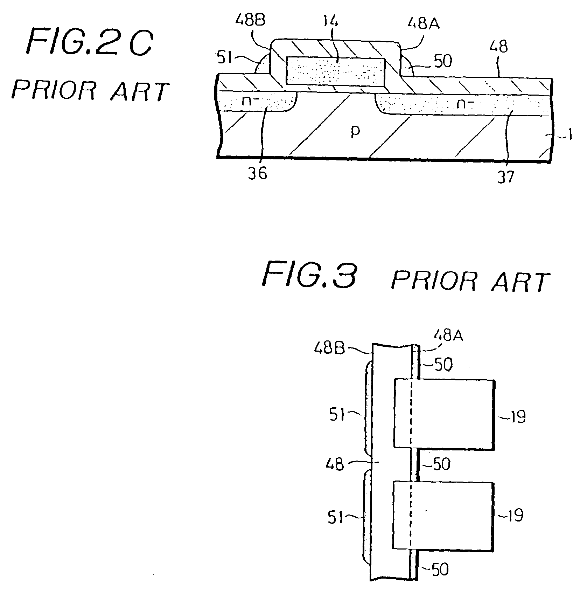

FIGS.2A through 2C are cross sectional views and FIG.3 is a plan view for explaining the side wall SiO₂ layers 41 and 42. For the sake of convenience, a consideration will be given of a case where the storage electrode 19 is formed without forming the side wall SiO₂ layers 41 and 42 at the side wall portions of the gate electrode 14.

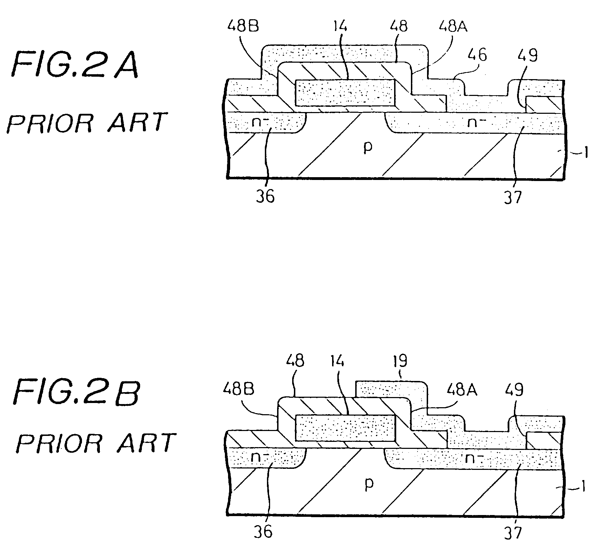

In this case, a SiO₂ layer 48 which covers the gate electrode 14 and the n⁻-type diffusion layers 36 and 37 are first formed as shown in FIG.2A. After forming a contact hole 49 in the SiO₂ layer 48, the polysilicon layer 46 is formed on the entire surface of the stacked structure. Then, after the resistance of this polysilicon layer 46 is reduced by carrying out an ion implantation with respect to the polysilicon layer 46, an RIE is carried out and the polysilicon layer 46 is patterned to form the storage electrode 19 as shown in FIG.2B.

However, side wall portions 48A and 48B of the SiO₂ layer 48 along the gate electrode 14 are formed vertically in accordance with the shape of the side wall portions of the gate electrode 14. For this reason, when the polysilicon layer 46 is etched by the RIE and the storage electrode 19 is formed as shown in FIG.2B, polysilicon (identified by reference numerals 50 and 51) remains at the side wall portions 48A and 48B of the SiO₂ layer 48 as shown in FIGS.2C and 3. For example, there is a problem in that the polysilicon 50 may extend across two mutually adjacent storage electrodes 19 and short-circuit these storage electrodes 19. On the other hand, there is a problem in that the polysilicon 51 may come off during a subsequent process and adhere across two mutually adjacent storage electrodes 19 and short-circuit these storage electrodes 19.

The side wall portions of the gate electrode 14 may be formed as overhangs. In this case, the side wall portions 48A and 48B of the SiO₂ layer 48 are also formed as overhangs. For this reason, when the RIE is carried out with respect to the polysilicon layer 46 and the storage electrode 19 is formed, polysilicon inevitably remains at the side wall portions 48A and 48B. When the side wall portions of the gate electrode 14 are formed as overhangs, the above described problems become particularly notable.

Accordingly, in the conventional DRAM, the side wall SiO₂ layers 41 and 42 are formed at the side wall portions of the gate electrode 14 as shown in FIG.1D and the vertical stepped portions at the side wall portions of the gate electrode 14 are flattened so as to facilitate the formation of the storage electrode 19.

However, the conventional DRAM described above suffer from the following problems.

First, when forming the side wall SiO₂ layers 41, 42, 43 and 44 by the RIE as shown in FIG.1D, the surface of the n⁻-type diffusion layer 37 is subjected to the plasma atmosphere. As a result, there is a problem in that a crystal defect is generated at the surface of the n⁻-type diffusion layer 37 due to contamination of metals such as iron, copper and nickel which are included in the internal wall of a chamber containing the plasma or included in the plasma atmosphere caused by electrode erosion. Because the storage electrode 19 is connected to the surface of the n⁻-type diffusion layer 37, the charge storage characteristic (refresh characteristic) of the memory cell 3 is deteriorated by the crystal defect.

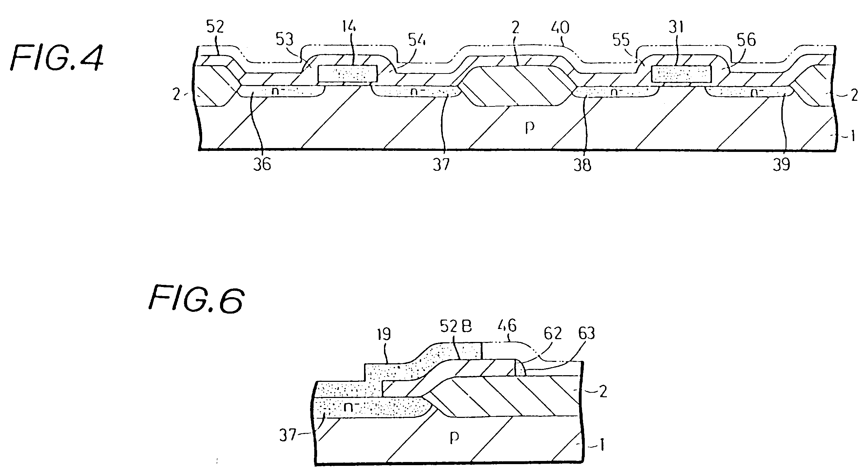

Hence, a description will be given of a conceivable method of producing the DRAM to eliminate the problem of the conventional method, by referring to FIG.4. According to this conceivable method, when etching by the RIE the SiO₂ layer 40 which is formed on the entire surface of the stacked structure in the step shown in FIG.1C, the etching is ended halfway as shown in FIG.4. Then, a SiO₂ layer 52 having a predetermined thickness is formed, and side wall SiO₂ layers 53, 54, 55 and 56 are formed at the side wall portions of the gate electrodes 14 and 31.

According to this conceivable method, it is possible to form the side wall SiO₂ layers 53 and 54 at the side wall portions of the gate electrode 14 without subjecting the n⁻-type diffusion layer 37 to the plasma atmosphere. For this reason, it is possible to protect the n⁻-type diffusion layer 37 from metal contamination and easily form the storage electrode 19.

However, a problem occurs according to this conceivable method at a latter stage when the n⁺-type source diffusion layer 9 and the n⁺-type drain diffusion layer 12 of the nMOS FET 5 and the n⁺-type source diffusion layer 26 and the n⁺-type drain diffusion layer 29 of the nMOS FET 23 are formed as shown in FIG.1E described above.

In other words, when forming the n⁺-type source diffusion layer 9, the n⁺-type drain diffusion layer 12, the n⁺-type source diffusion layer 26 and the n⁺-type drain diffusion layer 29 according to the conceivable method of FIG.4, it is necessary to accelerate the As ion implantation into the p-type Si substrate 1 such that the As ions penetrate the SiO₂ layer 52. But it is difficult to control the thickness of the SiO₂ layer 52 with a high accuracy according to the RIE, and the As ions must be implanted with an energy which takes into consideration the thickness distribution of the SiO₂ layer 52. Hence, when the As ion implantation is carried out under such consideration, the As ions penetrate the gate electrodes 14 and 31 and reach the channel region, thereby introducing undesirable effects on the characteristics of the nMOS FETs 5 and 23.

On the other hand, there is another problem in that the ion implantation with a high acceleration and a high dosage leads to a poor throughput.

Second, the conventional DRAM shown in FIG.1K has the n⁺-type drain diffusion layer 12 provided in the nMOS FET 5, but the As ion implantation with respect to the p-type Si substrate 1 must be carried out with a high dosage in order to form this n⁺-type drain diffusion layer 12. In this case, the region which is subjected to the As ion implantation is transformed into an amorphous state, and it becomes necessary to thereafter carry out a thermal process to transform the region back into a crystal state. But when such a recrystallization is carried out, a dislocation loop is generated in the n⁺-type drain diffusion layer 12 and there is a problem in that the charge storage characteristic of the memory cell 3 is deteriorated thereby.

In addition, in the conventional DRAM shown in FIG.1K, the tip end of the side wall SiO₂ layer 42 makes direct contact with the p-type Si substrate 1 as shown in FIG.1D, and an angle the tip end of the side wall SiO₂ layer 42 makes with respect to the surface of the p-type Si substrate 1 cannot be made small. As a result, there are problems in that a stress is concentrated at the tip end portion of the side wall SiO₂ layer 42 and an edge dislocation is generated in the n⁻-type drain diffusion layer 11 or the n⁺-type drain diffusion layer 12 about this portion when the n⁺-type drain diffusion layer 12 is formed (recrystallization takes place), thereby deteriorating the charge storage characteristic of the memory cell 3.

The dislocation loop and the edge dislocation are also generated in the source diffusion layer 7. However, since the source diffusion layer 7 passes the charge, the dislocation loop and the edge dislocation in the source diffusion layer 7 essentially do not affect the charge storage characteristic of the memory cell 3.

The transistor which makes up the memory cell merely controls the input/output of the charge. Thus, virtually no problems are generated from the point of view of the operation characteristic of this transistor even when the resistances of the source diffusion layer and the drain diffusion layer thereof are large. Accordingly, it is sufficient to provide only the n⁻-type source diffusion layer and the n⁻-type drain diffusion layer with respect to the transistor which makes up the memory cell, and this in effect avoids the generation of the dislocation loop and the edge dislocation in the drain diffusion layer.

On the other hand, the current driving capability must be ensured for the transistor which makes up the peripheral circuit. For this reason, the resistances of the source diffusion layer and the drain diffusion layer of this transistor must be small. As a result, the n⁺-type source diffusion layer and the n⁺-type drain diffusion layer must be provided for the transistor which makes up the peripheral circuit.

Therefore, in the conventional DRAM, there is a demand to form the transistor which makes up the memory cell so that a source diffusion layer and a drain diffusion layer thereof are respectively made solely from an n⁻-type source diffusion layer and an n⁻-type drain diffusion layer, and to form the transistor which makes up the peripheral circuit so that a source diffusion layer includes an n⁻-type source diffusion layer and an n⁺-type source diffusion layer and a drain diffusion layer includes an n⁻-type drain diffusion layer and an n⁺-type drain diffusion layer.

### SUMMARY OF THE INVENTION

Accordingly, it is a general object of the present invention to provide a semiconductor device and production method thereof in which the problems described above are eliminated.

The known semiconductor device described above comprises: a semiconductor substrate; a first transistor formed on said semiconductor substrate, said first transistor having a first source diffusion region, a first drain diffusion region and a first gate electrode mounted on the substrate and disposed between said first diffusion regions, said first source diffusion region and said first drain diffusion region being formed in said semiconductor substrate; a second transistor formed on said semiconductor substrate adjacent to said first transistor, said second transistor having a second source diffusion region, a second drain diffusion region and a second gate electrode mounted on the substrate and disposed between said second diffusion regions, said second source diffusion region and said second drain diffusion region being formed in said semiconductor substrate; and a field oxide layer formed on said semiconductor substrate between the first and second transistors for isolating said first and second transistors.

According to the present invention, there is provided a semiconductor device as defined in claim 1.

According to the semiconductor device of the present invention, it is possible to suppress the generation of crystal defect by not subjecting the impurity region of the first transistor to an etching atmosphere.

A method of producing a semiconductor device comprising two adjacent transistors on a semiconductor substrate with a field oxide layer between the two transistors is also known, the method comprising the steps of: forming a first gate of a first transistor and a second gate of a second transistor on the semiconductor substrate having the field oxide layer for isolating said first and second transistors; and forming impurity diffusion regions in said semiconductor substrate to make a first source diffusion region and a first drain diffusion region of said first transistor, the first diffusion regions being disposed adjacent to opposite sides of the first gate, and a second source diffusion region and a second drain diffusion region of said second transistor, the second diffusion regions being disposed adjacent to opposite sides of the second gate.

According to the present invention, there is provided a method as defined in claim 8.

According to the method of the present invention, it is possible to suppress the generation of crystal defect by not subjecting the impurity region of the first transistor to an etching atmosphere.

Other objects and further features of the present invention will be apparent from the following detailed description when read in conjuction with the accompanying drawings.

### BRIEF DESCRIPTION OF THE DRAWINGS

FIGS.1A through 1K are cross sectional views for explaining a conventional method of producing a DRAM;
FIGS.2A through 2C are cross sectional views and FIG.3 is a plan view respectively showing an essential part of the DRAM shown in FIG.1K for explaining functions of side wall SiO₂ layers which are formed at a gate electrode of an nMOS FET which makes up a memory cell of the DRAM shown in FIG.1K;
FIG.4 is a cross sectional view for explaining a conceivable method of producing a DRAM to eliminate the problem of the conventional method;
FIGS.5A through 5D are cross sectional views for explaining a first conceivable method of producing a semiconductor device;
FIG.6 is a cross sectional view showing a part of the semiconductor device shown in FIG.5D on an enlarged scale; and
FIGS.7A through 7K are cross sectional views for explaining a method of producing a semiconductor device according to the present invention.

### DESCRIPTION OF THE PREFERRED EMBODIMENTS

First, a description will be given of a first conceivable method of producing a semiconductor device, by referring to FIGS.5A through 5D. In FIGS.5A through 5D, those parts which are essentially the same as those corresponding parts in FIGS.1A through 1K, 2A through 2C, 3 and 4 are designated by the same reference numerals, and a description thereof will be omitted. This method produces a first embodiment of semiconductor device.

In this embodiment, the steps described in conjunction with FIGS.1A through 1C and 4 are carried out to form the SiO₂ layer 52 as shown in FIG.4. Thereafter, as shown in FIG.5A, a part 52A of the SiO₂ layer 52 corresponding to the peripheral circuit is removed by an RIE so that only a part 52B of the SiO₂ layer 52 remains. In this case, side wall SiO₂ layers 57 and 58 are formed at the side wall portions of the gate electrode 31. In this embodiment, an nMOS FET 60 which uses the n⁻-type diffusion layer 36 as the n⁻-type source diffusion layer and the n⁻-type diffusion layer 37 as the n⁻-type drain diffusion layer makes up the memory cell 3.

The nMOS FET 23 has the LDD structure, but the nMOS FET 60 does not have the LDD structure because an undesirable current leak is introduced at the pn junction of the LDD structure. Such a current leak is generated due to a surface deterioration caused by the RIE which is carried out with respect to the p-type Si substrate 1. This current leak deteriorates the charge storage characteristic of the memory cell 3, and a transistor having the LDD structure is unsuitable for use as the transistor of the memory cell 3. On the other hand, such a current leak is negligible in the case of the transistor which is used for the peripheral circuit 4, as long as a satisfactory current driving capability is ensured. This is the reason why the nMOS FET 23 has the LDD structure while the nMOS FET 60 does not.

Next, a thermal oxidation is carried out to form a SiO₂ layer 59 having a thickness of 150 Å, for example, on the exposed surface of the p-type Si substrate 1 and the exposed surface of the gate electrode 31 as shown in FIG.5B. Then, the part 52B, the field oxide layer 2, the gate electrode 31 and the side wall SiO₂ layers 57 and 58 are used as a mask when implanting As ions into the p-type Si substrate 1 with an energy of 50 keV and a dosage of 4 x 10¹⁵ cm⁻², for example, so as to form the n⁺-type source diffusion layer 26 and the n⁺-type drain diffusion layer 29. Of course, a resist mask may be used in place of the part 52B of the SiO₂ layer 52.

As a result, the nMOS FET 23 having the source diffusion layer 24 which is made up of the n⁻-type source diffusion layer 25 and the n⁺-type source diffusion layer 26, and the drain diffusion layer 27 which is made up of the n⁻-type drain diffusion layer 28 and the n⁺-type drain diffusion layer 29 is formed.

Then, as shown in FIG.5C, a contact hole 61 is formed in the part 52B above the n⁻-type drain diffusion layer 37. Thereafter, the polysilicon layer 46 having the thickness of 2000 Å, for example, is formed on the entire surface of the stacked structure, and the resistance of this polysilicon layer 46 is reduced by carrying out an As ion implantation. The storage electrode 19 shown in FIG.5D is formed by patterning the polysilicon layer 46 by an RIE.

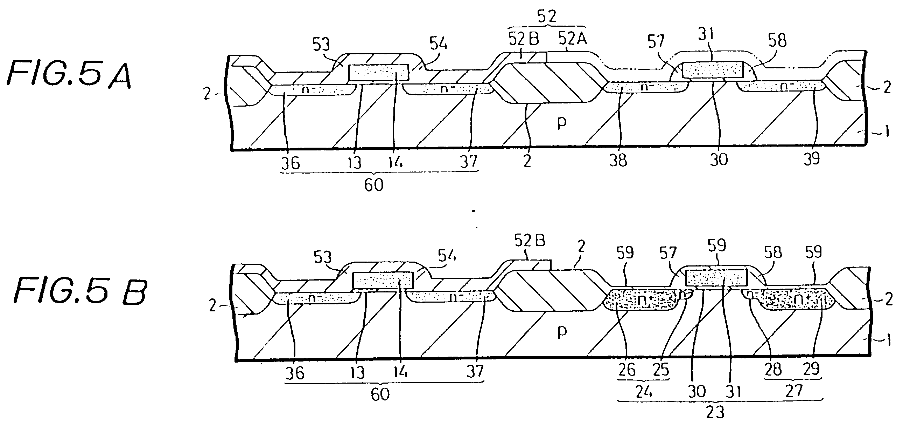

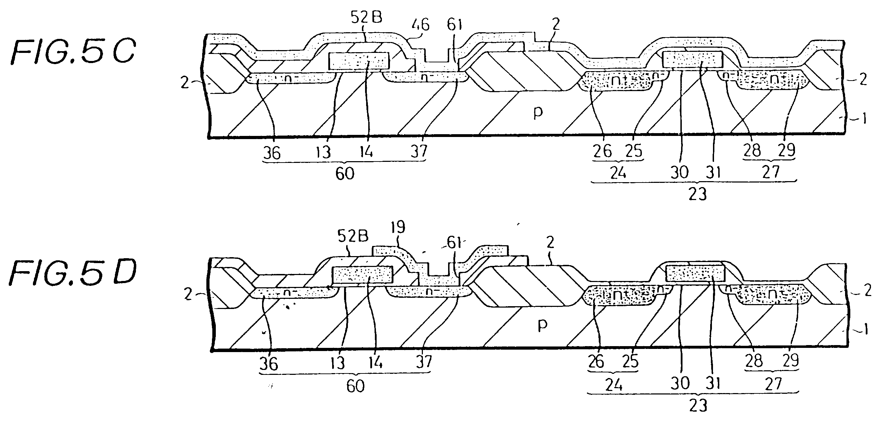

The problems of the conventional DRAM are eliminated according to this embodiment. However, as shown in FIG.6 on an enlarged scale, a side wall portion 62 at the end of the part 52B is formed vertically. Consequently, when the polysilicon layer 46 is etched by the RIE to form the storage electrode 19, polysilicon 63 inevitably remains at the side wall portion 62 of the part 52B. This polysilicon 63 may come off during the subsequent process in which the exposed surface of the storage electrode 19 is naturally oxidized and removed using the HF solution. The polysilicon 63 which comes off may adhere across two mutually adjacent storage electrodes 19 and cause a short-circuit.

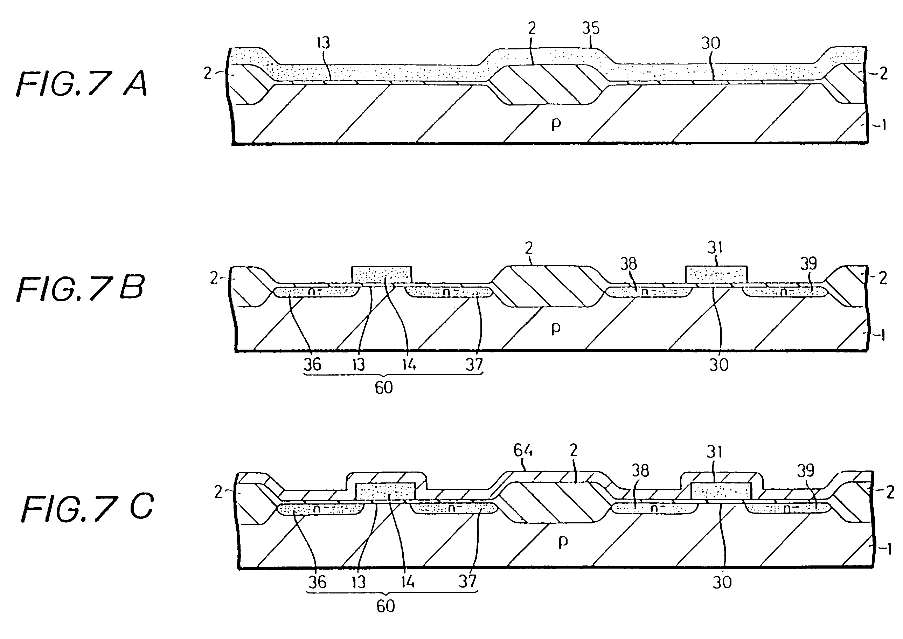

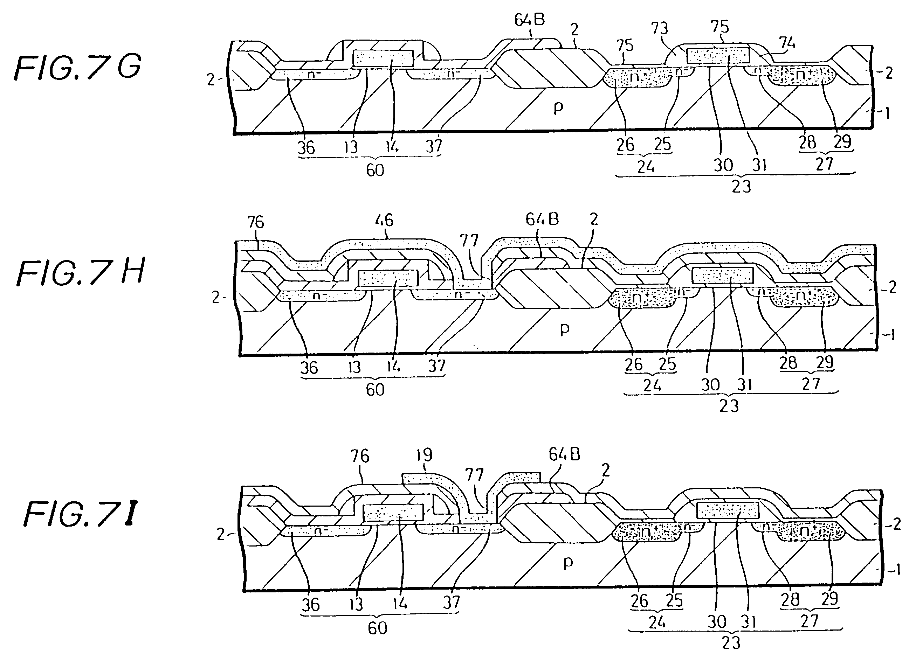

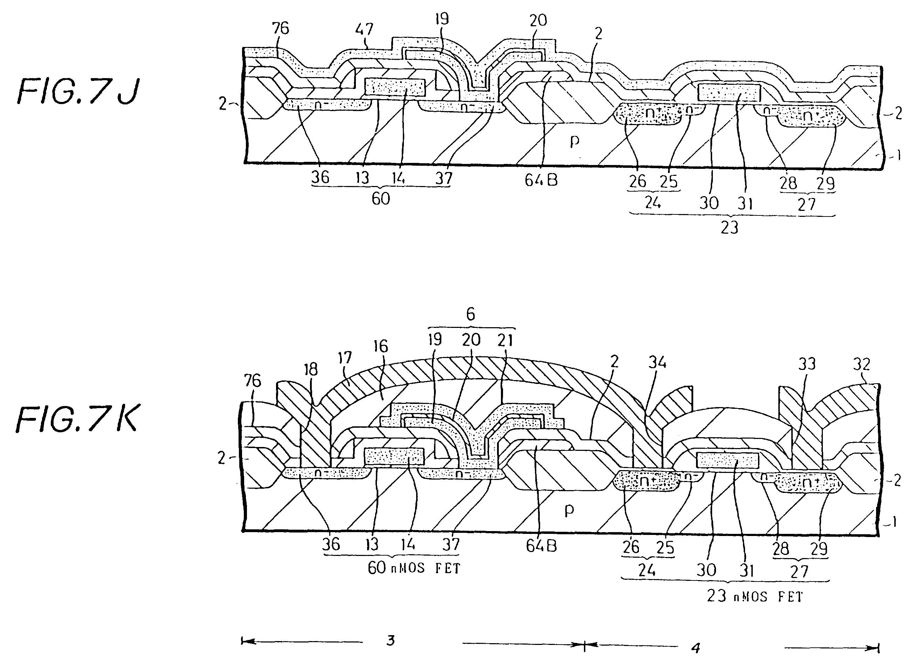

Next, a description will be given of a second method of producing a semiconductor device which is according to the present invention and which eliminates the problems encountered in the first conceivable embodiment, by referring to FIGS.7A through 7K. In FIGS.7A through 7K, those parts which are essentially the same as those corresponding parts in FIGS.1A through 1K, 2A through 2C, 3, 4, 5A through 5D and 6 are designated by the same reference numerals, and a description thereof will be omitted. This embodiment of the method produces a semiconductor device according to the present invention.

In this embodiment, steps similar to those described in conjunction with FIGS.1A and 1B are carried out as shown in FIGS.7A and 7B.

In other words, the p-type Si substrate 1 is prepared as shown in FIG.7A. The surface of this p-type Si substrate 1 is selectively oxidized to form the field oxide layer 2 which has a thickness of 5000 Å, for example. Then, the SiO₂ layers 13 and 30 are formed in the device region by a thermal oxidation to a thickness of 150 Å, for example. Furthermore, the polysilicon layer 35 having a thickness of 2000 Å, for example, is formed on the entire surface of the stacked structure by a CVD.

Next, the polysilicon layer 35 is patterned, and as shown in FIG.7B, the gate electrodes 14 and 31 are formed. Then, the gate electrodes 14 and 31 are used as a mask when implanting phosphorous (P) ions into the p-type Si substrate 1 with an energy of 50 keV and a dosage of 1 x 10¹³ cm⁻², for example. As a result, the n⁻-type diffusion layers 36, 37, 38 and 39 are formed.

In this embodiment, the nMOS FET 60 makes up the memory cell 3, and this nMOS FET 60 uses the n⁻-type diffusion layer 36 as the n⁻-type source diffusion layer and the n⁻-type diffusion layer 37 as the n⁻-type drain diffusion layer.

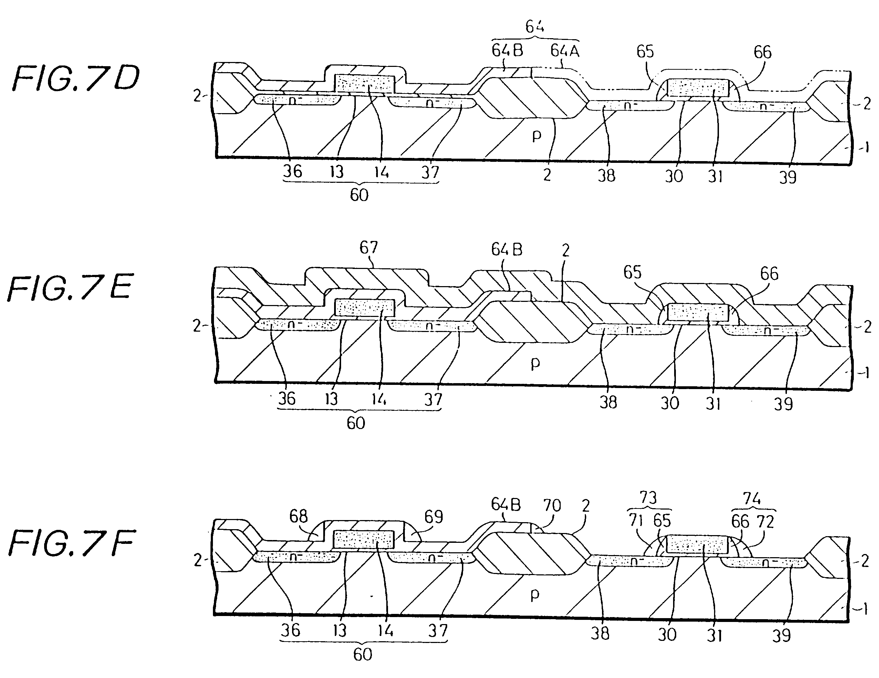

Then, as shown in FIG.7C, a SiO₂ layer 64 having a thickness of 1000 Å, for example, is formed on the entire surface of the stacked structure by a CVD. A part 64A of the SiO₂ layer 64 corresponding to the peripheral circuit is removed by an RIE so that only a part 64B of the SiO₂ layer 64 corresponding to the memory cell remains as shown in FIG.7D. The RIE is ended by making an endpoint detection which detects a change in a plasma light emission spectrum intensity when the surface of the p-type Si substrate 1 is exposed at the peripheral circuit. In this case, side wall SiO₂ layers 65 and 66 are formed at the side wall portions of the gate electrode 31.

Next, as shown in FIG.7E, a SiO₂ layer 67 having a thickness of 2000 Å, for example, is formed on the entire surface of the stacked structure by a CVD. Thereafter, a RIE is carried out with respect to this SiO₂ layer 67 so as to partially expose the n⁻-type diffusion layers 38 and 39 as shown in FIG.7F. The endpoint detection described above is also used to detect the end of this RIE. Thus, the surface of the p-type Si substrate 1 at the memory cell will not be subjected to the plasma. Side wall SiO₂ layers 68, 69 and 70 are respectively formed at the side wall portions of the part 64B along the gate electrode 14 and at the side wall portion on the end of the part 64B. In addition, side wall SiO₂ layers 71 and 72 are respectively formed at the side wall portions of the side wall SiO₂ layers 65 and 66. As a result, a side wall SiO₂ layer 73 in which the side wall SiO₂ layers 65 and 71 are integrated, and a side wall SiO₂ layer 74 in which the side wall SiO₂ layers 66 and 72 are integrated are formed.

Next, a thermal oxidation is carried out to form a SiO₂ layer 75 having a thickness of 150 Å, for example, on the exposed surfaces of the p-type Si substrate 1 and the gate electrode 31. Thereafter, the part 64B of the SiO₂ layer 64, the field oxide layer 2, the gate electrode 31 and the side wall SiO₂ layers 73 and 74 are used as a mask when implanting As ions into the p-type Si substrate 1 with an energy of 50 keV and a dosage of 4 x 10¹⁵ cm⁻², for example, so as to form the source diffusion layer 24 which is made up of the n⁻-type source diffusion layer 25 and the n⁺-type source diffusion layer 26 and the drain diffusion layer 27 which is made up of the n⁻-type drain diffusion layer 28 and the n⁺-type drain diffusion layer 29. Of course, a resist mask may be used at the memory cell. In addition, an oxidation process may be made after the step shown in FIG.7D and the As⁺ ion implantation may be carried out thereafter.

Therefore, the nMOS FET 23 which has the source diffusion layer 24 and the drain diffusion layer 27 is formed.

Next, as shown in FIG.7H, a SiO₂ layer 76 having a thickness of 1000 Å, for example, is formed by a CVD. Then, a contact hole 77 is formed in the SiO₂ layer 76 and the part 64B of the SiO₂ layer 64 above the n⁻-type source diffusion layer 37. In addition, the polysilicon layer 46 having a thickness of 2000 Å, for example, is formed on the entire surface of the stacked structure. The resistance of this polysilicon layer 46 is reduced by implanting As ions with an energy of 50 keV and a dosage of 1 x 10¹⁵ cm⁻², for example.

Thereafter, the polysilicon layer 46 is patterned as shown in FIG.7I, and the storage electrode 19 is formed. This storage electrode 19 makes an ohmic contact with the n⁺-type drain diffusion layer 11 via the contact hole 77. A natural oxide layer which is formed at the exposed surface of the storage electrode 19 is removed by an etching using the HF solution.

A thermal oxidation is carried out to form the SiO₂ capacitor insulator layer 20 which has a thickness of 100 Å, for example, on the exposed surface of the storage electrode 19 as shown in FIG.7J. The polysilicon layer 47 having a thickness of 2000 Å, for example, is formed on the entire surface of the stacked structure as shown in FIG.7J, and P is thermally diffused into the polysilicon layer 47 to reduce the resistance.

Then, this polysilicon layer 47 is patterned to form the confronting electrode 21 as shown in FIG.7K. In addition, the PSG layer 16 is formed on the entire surface of the stacked structure to a thickness of 5000 Å, for example, as shown in FIG.7K.

The contact holes 18, 33 and 34 are formed in the PSG layer 16 as shown in FIG.7K, and the bit line 17 and the other interconnection 32 are formed. As a result, the second embodiment of the DRAM having the stacked capacitor 6 is obtained.

In this embodiment, the side wall SiO₂ layers 68, 69 and 70 are formed at the side wall portions of the part 64B of the SiO₂ layer 64 provided below the storage electrode 19 as shown in FIG.7F, so as to flatten the vertical stepped portion of the side wall portions. Thereafter when the polysilicon layer 46 is etched to form the storage electrode 19, it is possible to prevent the polysilicon from remaining at the side wall portion of the part 64B as shown in FIGS.7H and 7I. As a result, it is possible to positively prevent the mutually adjacent storage electrodes 19 from being short-circuited by a remaining polysilicon piece, and the formation of the storage electrode 19 is facilitated.

In addition, according to this embodiment, the surface of the n⁻-type drain diffusion layer 37 to which the storage electrode 19 connects is covered by the part 64B of the SiO₂ layer 64 as shown in FIG.7D. Hence, the surface of the n⁻-type drain diffusion layer 37 will not be subjected to the plasma atmosphere when the SiO₂ layer 67 is etched as may be understood from FIGS.7E and 7F. For this reason, the surface of the n⁻-type drain diffusion layer 37 is positively protected from metal contamination. Furthermore, as shown in FIG.7F, the side wall SiO₂ layer 69 above the n⁻-type drain diffusion layer 37 is formed via the part 64B of the SiO₂ layer 64. Hence, the stress at the tip end of the part 64B with respect to the p-type Si substrate 1 is reduced. Moreover, since the drain diffusion layer of the nMOS FET 60 is formed only from the n⁻-type drain diffusion layer 37 and no ion implantation of impurity needs to be made to form an n⁺-type drain diffusion layer, it is possible to prevent the generation of crystal defect such as the dislocation loop and the edge dislocation which occur during a recrystallization process after the ion implantation of the impurity at a high dosage. Accordingly, the charge storage characteristic of the memory cell 3 can be improved.

In addition, in this embodiment, the nMOS FET 23 which forms the peripheral circuit has the LDD structure and is provided with the n⁺-type source diffusion layer 26 and the n⁺-type drain diffusion layer 29. Thus, the resistances of the source diffusion layer 24 and the drain diffusion layer 27 can be made small. Therefore, it is possible to ensure a sufficient current driving capability as a transistor of the peripheral circuit 4.

In other words, it is possible to simultaneously achieve three goals. First, it is possible to facilitate the formation of the storage electrode 19 by flattening the vertical stepped portion of the part 64B of the SiO₂ layer 64 which is formed below the storage electrode 19. Second, it is possible to improve the charge storage characteristic of the memory cell 3 by suppressing the generation of crystal defect in the n⁻-type drain diffusion layer 37 of the nMOS FET 60 to which n⁻-type drain diffusion layer 37 the storage electrode 19 connects. Third, it is possible to ensure a sufficient current driving capability for the nMOS FET 23 which forms the peripheral circuit 4 by reducing the resistances of the source diffusion layer 24 and the drain diffusion layer 27 of the nMOS FET 23.

In this embodiment, a first transistor forms the memory cell and a second transistor forms the peripheral circuit. However, the first transistor may form a sense amplifier of the semiconductor device.

In the described embodiment, the present invention is applied to the DRAM having stacked capacitors. However, the present invention is similarly applicable to other semiconductor devices such as a static RAM.

## Claims

1. A semiconductor device comprising a semiconductor substrate (1); a first transistor (60) formed on said semiconductor substrate, said first transistor having a first source diffusion region (37), a first drain diffusion region (36) and a first gate electrode (14) mounted on the substrate and disposed between said first diffusion regions (36, 37), said first source diffusion region and said first drain diffusion region being formed in said semiconductor substrate; a second transistor (23) formed on said semiconductor substrate adjacent to said first transistor, said second transistor having a second source diffusion region (24), a second drain diffusion region (27) and a second gate electrode (31) mounted on the substrate and disposed between said second diffusion regions (24, 27), said second source diffusion region and said second drain diffusion region being formed in said semiconductor substrate; and a field oxide layer (2) formed on said semiconductor substrate between the first and second transistors (60, 23) for isolating said first and second transistors, characterized in that there are provided :
a first insulator layer (64B, 65, 66) which covers the surface of said semiconductor substrate (1), such that said first insulator layer covers the entire surface of the first transistor (60) and the side wall portions of the second gate electrode (31) of the second transistor (23);
a side wall insulating layer (68-72) being formed on said first insulator layer at the side wall portions of the first gate electrode (14), at the edge region of the first insulator layer (64B) and at the side wall portions of the second gate electrode; and
a second insulator layer (76) formed over said first and second transistors (60, 23), over the side wall insulating layer (68-72), said first and second insulator layers (64B, 76) being provided with contact holes for terminal regions of the transistors (60, 23).

2. The semiconductor device as claimed in claim 1, characterized in that said second transistor (23) has a lightly doped drain (LDD) structure.

3. The semiconductor device as claimed in claim 1 or 2, characterized in that said semiconductor substrate (1) is of a first semiconductor type, said first source diffusion region (36) and said first drain region (37) of said first transistor (60) are doped to a second semiconductor type with a first dosage, said second source diffusion region (24) of said second transistor (23) includes a first source diffusion layer (25) doped to the second semiconductor type with a second dosage and a second source diffusion layer (26) doped to the second semiconductor type with a third dosage, and said second drain diffusion region (27) of said second transistor includes a first drain diffusion layer (28) doped to the second semiconductor type with the second dosage and a second drain diffusion layer (29) doped to the second semiconductor type with the third dosage, said first and second semiconductor types being different semiconductor types, said first and second dosages being lower than said third dosage.

4. The semiconductor device as claimed in claim 3, characterized in that said first and second semiconductor types respectively are p-type and n-type semiconductors, and said first and second transistors (60, 23) are n-channel insulated-gate type field effect transistors.

5. The semiconductor device as claimed in any of claims 1 to 4, characterized in that said first transistor (60) forms a memory cell (3) of a semiconductor memory device and said second transistor (23) forms a peripheral circuit (4) of the semiconductor memory device.

6. The semiconductor device as claimed in claim 5, characterized in that there are further provided a stacked capacitor (6) formed on said second insulator layer (76) and coupled to said first transistor (60) to form the memory cell (3) of the semiconductor memory device, and a contact hole (77) formed in said first and second insulator layers (64B, 76), said stacked capacitor making contact with said first drain diffusion region (37) via said contact hole.

7. The semiconductor device as claimed in any of claims 1 to 6, characterized in that said first and second insulator layers (64B, 76) are made of silicon dioxide.

8. A method of producing a semiconductor device comprising two adjacent transistors on a semiconductor substrate (1) with a field oxide layer (2) between the two transistors, the method comprising the steps of:
forming a first gate (14) of a first transistor (60) and a second gate (31) of a second transistor (23) on the semiconductor substrate (1) having the field oxide layer (2) for isolating said first and second transistors; and
forming impurity diffusion regions (36, 37, 24, 27) in said semiconductor substrate to make a first source diffusion region (36) and a first drain diffusion region (37) of said first transistor the first diffusion regions (36, 37) being disposed adjacent to opposite sides of the first gate (14), and a second source diffusion region (24) and a second drain diffusion region (27) of said second transistor, the second diffusion regions (24, 27) being disposed adjacent to opposite sides of the second gate (31), characterized in that there are provided the steps of :
forming a first insulator layer (64B; 65, 66) which covers the surface of said semiconductor substrate (1) such that said first insulator layer (64B) covers the entire surface of the first transistor (60) and the side wall portions of the second gate (31) of the second transistor (23);
forming a side wall insulation layer (68-72) on said first insulator layer at
(i) side wall portions of the first gate (14) and at the edge region of the first insulator layer, and at
(ii) the side wall portions (73, 74) of said second gate (31) of said second transistor (23),
the side wall insulation layer (68-72) being formed by carrying out an anisotropic etching with respect to an initial insulation layer (67) which covers the semiconductor substrate (1); and
forming a second insulator layer (75) which covers exposed surfaces of said semiconductor substrate and said second gate of said second transistor,
said step of forming the first insulator layer (64B, 65, 66) including the substeps of forming said first insulator layer (64) on the entire surface of said semiconductor substrate (1) including said first and second gates (14, 31), and removing said first insulator layer (64A) from said second transistor (23) by an anisotropic etching.

9. The method as claimed in claim 8, characterized in that said step of forming the second insulator layer forms said second insulator layer by a thermal oxidation.

10. The method as claimed in claim 8 or 9, characterized in that said second transistor (23) has a lightly doped drain (LDD) structure.

11. The method as claimed in any of claims 8 to 10, characterized in that said semiconductor substrate (1) is of a first semiconductor type, said step of forming the impurity diffusion regions dopes said first and second source diffusion regions (36, 24) and said first and second drain regions (37, 27) of said first and second transistors (60, 23) to a second semiconductor type with a first dosage, said first and second semiconductor types being different semiconductor types.

12. The method as claimed in claim 11, characterized in that there is further provided the step of doping a portion (26, 29) of each of said second source diffusion region (24) and said second drain diffusion region (27) of said second transistor (23) to the second semiconductor type with a second dosage, said first dosage being lower than said second dosage.

13. The method as claimed in claim 12, characterized in that said first and second semiconductor types respectively are p-type and n-type semiconductors, and said first and second transistors (60, 23) are n-channel insulated-gate type field effect transistors.

14. The method as claimed in any of claims 8 to 13, characterized in that said first transistor (60) forms a memory cell (3) of a semiconductor memory device and said second transistor (23) forms a peripheral circuit (4) of the semiconductor memory device.

15. The method as claimed in claim 14, characterized in that there are further provided the steps of forming a contact hole (61) in said first insulator layer (52B), and forming a stacked capacitor (6) on said first insulator layer, said stacked capacitor having a storage electrode (19) which makes contact with said first drain diffusion region (37) via said contact hole to form the memory cell (3) of the semiconductor memory device.

16. The method as claimed in any of claims 8 to 15, characterized in that said first and second insulator layers (52B) are made of silicon dioxide.

17. The method as claimed in claim 12, characterized in that said step of doping implants impurity ions into said second source diffusion region (24) and said second drain diffusion region (27) of said second transistor (23) using at least said second gate (31) and said first insulation layer (65, 66) and said side wall insulation layer (71, 72) at the side wall portions of said second gate as a mask.

## Patentansprüche

1. Halbleiterbauelement, umfassend ein Halbleitersubstrat (1); einen ersten Transistor (60), der auf dem Halbleitersubstrat ausgebildet ist und ein erstes Quellendiffusionsgebiet (37), ein erstes Senkendiffusionsgebiet (36) und eine erste Gateelektrode (14), die auf dem Substrat angebracht und zwischen den ersten Diffusionsgebieten (36, 37) angeordnet ist, hat, wobei das erste Quellendiffusionsgebiet und das erste Senkendiffusionsgebiet im Halbleitersubstrat ausgebildet sind; einen zweiten Transistor (23), der dem ersten Transistor benachbart auf dem Halbleitersubstrat ausgebildet ist und ein zweites Quellendiffusionsgebiet (24), ein zweites Senkendiffusionsgebiet (27) und eine zweite Gateelektrode (31), die auf dem Substrat angebracht und zwischen den zweiten Diffusionsgebieten (24, 27) angeordnet ist, hat, wobei das zweite Quellendiffusionsgebiet und das zweite Senkendiffusionsgebiet im Halbleitersubstrat ausgebildet sind; und eine Feldoxidschicht (2), die auf dem Halbleitersubstrat zwischen dem ersten und dem zweiten Transistor (60, 23) zur Isolierung des ersten und des zweiten Transistors angeordnet ist, dadurch gekennzeichnet, daß vorgesehen sind:
eine erste Isolierschicht (64B, 65, 66), welche die Oberfläche des Halbleitersubstrats (1) so bedeckt, daß die erste Isolierschicht die gesamte Oberfläche des ersten Transistors (60) und die Seitenwandabschnitte der zweiten Gateelektrode (31) des zweiten Transistors (23) bedeckt;
eine Seitenwandisolierschicht (68-72), die auf der ersten Isolierschicht an den Seitenwandabschnitten der ersten Gateelektrode (14), am Kantenbereich der ersten Isolierschicht (64B) und an den Seitenwandabschnitten der zweiten Gateelektrode ausgebildet ist; und
eine zweite Isolierschicht (76), die über dem ersten und dem zweiten Transistor (60, 23), über der Seitenwandisolierschicht (68-72) ausgebildet ist, wobei die erste und die zweite Isolierschicht (64B, 76) mit Kontaktlöchern für Anschlußbereiche der Transistoren (60, 23) ausgestattet sind.

2. Das Halbleiterbauelement wie in Anspruch 1 beansprucht, dadurch gekennzeichnet, daß der zweite Transistor (23) eine niedrig dotierte Senkenstruktur (LDD) hat.

3. Das Halbleiterbauelement wie in Anspruch 1 oder 2 beansprucht, dadurch gekennzeichnet, daß das Halbleitersubstrat (1) von einem ersten Halbleitertyp ist, das erste Quellendiffusionsgebiet (36) und das erste Senkengebiet (37) des ersten Transistors (60) zu einem zweiten Halbleitertyp mit einer ersten Dosierung dotiert sind, das zweite Quellendiffusionsgebiet (24) des zweiten Transistors (23) eine erste Quellendiffusionsschicht (25), die zum zweiten Halbleitertyp mit einer zweiten Dosierung dotiert ist, und eine zweite Quellendiffusionsschicht (26), die zum zweiten Halbleitertyp mit einer dritten Dosierung dotiert ist, umfaßt, und das zweite Senkendiffusionsgebiet (27) des zweiten Transistors eine erste Senkendiffusionsschicht (28), die zum zweiten Halbleitertyp mit der zweiten Dosierung dotiert ist, und eine zweite Senkendiffusionsschicht (29), die zum zweiten Halbleitertyp mit der dritten Dosierung dotiert ist, umfaßt, und daß der erste und der zweite Halbleitertyp verschiedene Halbleitertypen sind und die erste und die zweite Dosierung niedriger als die dritte Dosierung sind.

4. Das Halbleiterbauelement wie in Anspruch 3 beansprucht, dadurch gekennzeichnet, daß der erste und der zweite Halbleitertyp p- bzw. n-Halbleiter sind und der erste und der zweite Transistor (60, 23) n-Kanal-Feldeffekttransistoren mit isoliertem Gate sind.

5. Das Halbleiterbauelement wie in einem der Ansprüche 1 bis 4 beansprucht, dadurch gekennzeichnet, daß der erste Transistor (60) eine Speicherzelle (3) einer Halbleiter-Speichervorrichtung und der zweite Transistor (23) einen Peripherieschaltkreis (4) der Halbleiter-Speichervorrichtung bildet.

6. Das Halbleiterbauelement wie in Anspruch 5 beansprucht, dadurch gekennzeichnet, daß außerdem ein stapelförmiger Kondensator (6), der auf der zweiten Isolierschicht (76) ausgebildet und mit dem ersten Transistor (60) zur Bildung der Speicherzelle (3) der Halbleiter-Speichervorrichtung verbunden ist, und ein Kontaktloch (77), das in der ersten und der zweiten Isolierschicht (64B, 76) ausgebildet ist, vorgesehen sind, und daß der stapelförmige Kondensator mit dem ersten Senkendiffusionsgebiet (37) über das Kontaktloch Kontakt macht.

7. Das Halbleiterbauelement wie in einem der Ansprüche 1 bis 6 beansprucht, dadurch gekennzeichnet, daß die erste und die zweite Isolierschicht (64B, 76) aus Siliziumdioxid sind.

8. Verfahren der Herstellung eines Halbleiterbauelementes, das zwei benachbarte Transistoren auf einem Halbleitersubstrat (1) mit einer Feldoxidschicht (2) zwischen den zwei Transistoren umfaßt, welches Verfahren die Schritte umfaßt:
Bilden eines ersten Gates (14) eines ersten Transistors (60) und eines zweiten Gates (31) eines zweiten Transistors (23) auf dem Halbleitersubstrat (1) mit der Feldoxidschicht (2) zum Isolieren des ersten und des zweiten Transistors; und
Bilden von Verunreinigungsdiffusionsgebieten (36, 37, 24, 27) im Halbleitersubstrat, um ein erstes Quellendiffusionsgebiet (36) und ein erstes Senkendiffusionsgebiet (37) des ersten Transistors zu machen, wobei die ersten Diffusionsgebiete (36, 37) gegenüberliegenden Seiten des ersten Gates (14) benachbart angeordnet werden, sowie ein zweites Quellendiffusionsgebiet (24) und ein zweites Senkendiffusionsgebiet (27) des zweiten Transistors zu machen, wobei die zweiten Diffusionsgebiete (24, 27) gegenüberliegenden Seiten des zweiten Gates (31) benachbart angeordnet werden, dadurch gekennzeichnet, daß die Schritte vorgesehen sind:
Bilden einer ersten Isolierschicht (64B, 65, 66), welche die Oberfläche des Halbleitersubstrats (1) so bedeckt, daß die erste Isolierschicht (64B) die gesamte Oberfläche des ersten Transistors (60) und die Seitenwandabschnitte des zweiten Gates (31) des zweiten Transistors (23) bedeckt;
Bilden einer Seitenwandisolierschicht (68-72) auf der ersten Isolierschicht
(i) an Seitenwandabschnitten des ersten Gates (14) und am Kantenbereich der ersten Isolierschicht und an
(ii) den Seitenwandabschnitten (73, 74) des zweiten Gates (31) des zweiten Transistors (23),
welche Seitenwandisolierschicht (68-72) mittels Durchführung eines anisotropen Ätzens gegenüber einer Ausgangsisolierschicht (67), die das Halbleitersubstrat (1) bedeckt, gebildet wird; und
Bilden einer zweiten Isolierschicht (75), die zugängliche Oberflächen des Halbleitersubstrats und das zweite Gate des zweiten Transistors bedeckt,
welcher Schritt des Bildens der ersten Isolierschicht (64B, 65, 66) die Unterschritte des Bildens der ersten Isolierschicht (64) auf der gesamten Oberfläche des Halbleitersubstrats (1) einschließlich des ersten und des zweiten Gates (14, 31) sowie des Entfernens der ersten Isolierschicht (64A) von dem zweiten Transistor (23) durch ein anisotropes Ätzen umfaßt.

9. Das Verfahren wie in Anspruch 8 beansprucht, dadurch gekennzeichnet, daß der Schritt des Bildens der zweiten Isolierschicht die zweite Isolierschicht durch eine thermische Oxidation bildet.

10. Das Verfahren wie in Anspruch 8 oder 9 beansprucht, dadurch gekennzeichnet, daß der zweite Transistor (23) eine niedrig dotierte Senkenstruktur (LDD) hat.

11. Das Verfahren wie in einem der Ansprüche 8 bis 10 beansprucht, dadurch gekennzeichnet, daß das Halbleitersubstrat (1) von einem ersten Halbleitertyp ist, daß der Schritt des Bildens der Verunreinigungsdiffusionsgebiete das erste und das zweite Quellendiffusionsgebiet (36, 24) und das erste und das zweite Senkendiffusionsgebiet (37, 27) des ersten und des zweiten Transistors (60, 23) zu einem zweiten Halbleitertyp mit einer ersten Dosierung dotiert, und daß der erste und der zweite Halbleitertyp verschiedene Halbleitertypen sind.

12. Das Verfahren wie in Anspruch 11 beansprucht, dadurch gekennzeichnet, daß außerdem der Schritt des Dotierens eines Teils (26, 29) sowohl des zweiten Quellendiffusionsgebietes (24) als auch des zweiten Senkendiffusionsgebietes (27) des zweiten Transistors (23) zum zweiten Halbleitertyp mit einer zweiten Dosierung vorgesehen ist, und daß die erste Dosierung niedriger ist als die zweite Dosierung.

13. Das Verfahren wie in Anspruch 12 beansprucht, dadurch gekennzeichnet, daß der erste und der zweite Halbleitertyp jeweils p- bzw. n-Halbleiter sind und der erste und der zweite Transistor (60, 23) n-Kanal-Feldeffekttransistoren mit isoliertem Gate sind.

14. Das Verfahren wie in einem der Ansprüche 8 bis 13 beansprucht, dadurch gekennzeichnet, daß der erste Transistor (60) eine Speicherzelle (3) einer Halbleiter-Speichervorrichtung und der zweite Transistor (23) einen Peripherieschaltkreis (4) der Halbleiter-Speichervorrichtung bildet.

15. Das Verfahren wie in Anspruch 14 beansprucht, dadurch gekennzeichnet, daß außerdem die Schritte des Bildens eines Kontaktloches (61) in der ersten Isolierschicht (52B) und des Bildens eines stapelförmigen Kondensators (6) auf der ersten Isolierschicht vorgesehen sind, welcher stapelförmige Kondensator eine Speicherelektrode (19) hat, die mit dem ersten Senkendiffusionsgebiet (37) über das Kontaktloch zur Bildung der Speicherzelle (3) der Halbleiter-Speichervorrichtung Kontakt macht.

16. Das Verfahren wie in einem der Ansprüche 8 bis 15 beansprucht, dadurch gekennzeichnet, daß die erste und die zweite Isolierschicht (52B) aus Siliziumdioxid sind.

17. Das Verfahren wie in Anspruch 12 beansprucht, dadurch gekennzeichnet, daß der Schritt des Dotierens Verunreinigungsionen in das zweite Quellendiffusionsgebiet (24) und das zweite Senkendiffusionsgebiet (27) des zweiten Transistors (23) implantiert, und daß zumindest das zweite Gate (31) und die erste Isolierschicht (65, 66) und die Seitenwandisolierschicht (71, 72) an den Seitenwandabschnitten des zweiten Gates als Maske verwendet werden.

## Revendications

1. Dispositif à semiconducteur comprenant : un substrat semiconducteur (1) ; un premier transistor (60) formé sur ledit substrat semiconducteur, ledit premier transistor ayant une première région de diffusion de source (37), une première région de diffusion de drain (36), et une première électrode de grille (14) montée sur le substrat et disposée entre lesdites premières régions de diffusion (36, 37), ladite première région de diffusion de source et ladite première région de diffusion de drain étant formées dans ledit substrat semiconducteur ; un deuxième transistor (23) formé sur ledit substrat semiconducteur et adjacent au premier transistor, ledit deuxième transistor ayant une deuxième région de diffusion de source (24), une deuxième région de diffusion de drain (27), et une deuxième électrode de grille (31) montée sur le substrat et disposée entre lesdites deuxièmes régions de diffusion (24, 27), ladite deuxième région de diffusion de source et ladite deuxième région de diffusion de drain étant formées dans ledit substrat semiconducteur ; et une couche d'oxyde de grille (2) formée sur ledit substrat semiconducteur entre les premier et deuxième transistors (60, 23) afin d'isoler lesdits premier et deuxième transistors, caractérisé en ce qu'il est prévu :
une première couche d'isolant (64B, 65, 66) qui couvre la surface dudit substrat semiconducteur (1), de façon que ladite première couche d'isolant couvre toute la surface du premier transistor (60) et les parties parois latérales de la deuxième électrode de grille (31) du deuxième transistor (23);
une couche isolante de paroi latérale (68-72) étant formée sur ladite première couche d'isolant au niveau des parties parois latérales de la première électrode de grille (14), au niveau de la région de bord de la première couche d'isolant (64B), et au niveau des parties parois latérales de la deuxième électrode de grille; et
une deuxième couche d'isolant (76) formée sur lesdits premier et deuxième transistors (60, 23), sur la couche d'isolation de paroi latérale (68-72), lesdites première et deuxième couches d'isolant (64B, 76) étant dotées de trous de contact destinés à des régions bornes des transistors (60, 23).

2. Dispositif à semiconducteur selon la revendication 1, caractérisé en ce que ledit deuxième transistor (23) possède une structure à drain légèrement dopé (LDD).

3. Dispositif à semiconducteur selon la revendication 1 ou 2, caractérisé en ce que ledit substrat semiconducteur (1) est d'un premier type semiconducteur, ladite première région de diffusion de source (36) et la première région de diffusion de drain (37) dudit premier transistor (60) sont dopées à un deuxième type semiconducteur selon un premier dosage, ladite deuxième région de diffusion de source (24) dudit deuxième transistor (23) comporte une première couche de diffusion de source (25) dopée au deuxième type semiconducteur selon un deuxième dosage et une deuxième couche de diffusion de source (26) dopée au deuxième type semiconducteur selon un troisième dosage, et ladite deuxième région de diffusion de drain (27) dudit deuxième transistor comporte une première couche de diffusion de drain (28) dopé au deuxième type semiconducteur selon le deuxième dosage et une deuxième couche de diffusion de drain (29) dopé au deuxième type semiconducteur selon le troisième dosage, lesdits premier et deuxième types semiconducteurs étant des types semiconducteurs différents, lesdits premier et deuxième dosages étant inférieurs audit troisième dosages.

4. Dispositif à semiconducteur selon la revendication 3, caractérisé en ce que lesdits premier et deuxième types semiconducteurs sont respectivement les semiconducteurs de type p et n, et lesdits premier et deuxième transistors (60, 23) sont des transistors à effet de champ du type à grille isolée à canal n.

5. Dispositif à semiconducteur selon l'une quelconque des revendications 1 à 4, caractérisé en ce que ledit premier transistor (60) forme une cellule de mémoire (3) d'un dispositif de mémoire à semiconducteur et ledit deuxième transistor (23) forme un circuit périphérique (4) du dispositif de mémoire à semiconducteur.

6. Dispositif à semiconducteur selon la revendication 5, caractérisé en ce qu'il est en outre prévu un condensateur empilé (6) formé sur ladite deuxième couche d'isolant (76) et couplé audit premier transistor (60) afin de former la cellule de mémoire (3) du dispositif de mémoire à semiconducteur, et un trou de contact (77) formé dans lesdites première et deuxième couches d'isolant (64B, 76), ledit condensateur empilé établissant un contact avec ladite première région de diffusion de drain (37) via ledit trou de contact.

7. Dispositif à semiconducteur selon l'une quelconque des revendications 1 à 6, caractérisé en ce que lesdites première et deuxième couches d'isolant (64B, 76) sont constituées en dioxyde de silicium.

8. Procédé de production d'un dispositif à semiconducteur comprenant deux transistors adjacents sur un substrat semiconducteur (1) ayant une couche d'oxyde de champ (2) placée entre les deux transistors, le procédé comprenant les opérations suivantes :
former une première grille (14) d'un premier transistor (60) et une deuxième grille (31) d'un deuxième transistor (23) sur le substrat semiconducteur (1) ayant la couche d'oxyde de champ (2) pour isoler lesdits premier et deuxième transistors ; et
former des régions de diffusion d'impureté (36, 37, 24, 27) dans ledit substrat semiconducteur afin de réaliser une première région de diffusion de source (36) et une première région de diffusion de drain (37) dudit premier transistor, les premières régions de diffusion (36, 37) étant disposées adjacentes de côtés opposés de la première grille (14), ainsi qu'une deuxième région de diffusion de source (24) et une deuxième région de diffusion de drain (27) dudit deuxième transistor, les deuxièmes régions de diffusion (24, 27) étant disposées adjacentes de côtés opposés de la deuxième grille (31), caractérisé en ce que sont prévues les opérations suivantes :
former une première couche d'isolant (64B, 65, 66) qui couvre la surface dudit substrat semiconducteur (1) de façon que ladite première couche d'isolant (64B) couvre toute la surface du premier transistor (60) et les parties parois latérales de la deuxième grille (31) du deuxième transistor (23);
former une couche d'isolation de paroi latérale (68-72) sur ladite première couche d'isolant
(i) au niveau de parties parois latérales de la première grille (14) et à celui de la région de bord de la première couche d'isolant, et
(ii) au niveau des parties parois latérales (73, 74) de ladite deuxième grille (31) dudit deuxième transistor (23),
la couche d'isolation de paroi latérale (68-72) étant formée par exécution d'une gravure anisotrope relativement à une couche d'isolation initiale (67) qui couvre le substrat semiconducteur (1); et
former une deuxième couche d'isolant (75) qui couvre des surfaces exposées dudit substrat semiconducteur et de ladite deuxième grille dudit deuxième transistor,
ladite opération de formation de la première couche d'isolant (64B, 65, 66) comportant les sous-opérations qui consistent à former ladite première couche d'isolant (64) sur toute la surface dudit substrat semiconducteur (1) y compris lesdites première et deuxième grilles (14, 31), et à retirer dudit deuxième transistor (23), par une gravure anisotrope, ladite première couche d'isolant (64A).

9. Procédé selon la revendication 8, caractérisé en ce que ladite opération de formation de la deuxième couche d'isolant forme ladite deuxième couche d'isolant par une oxydation thermique.

10. Procédé selon la revendication 8 ou 9, caractérisé en ce que ledit deuxième transistor (23) possède une structure à drain légèrement dopé (LDD).

11. Procédé selon l'une quelconque des revendications 8 à 10, caractérisé en ce que ledit substrat semiconducteur (1) est d'un premier type semiconducteur, ladite opération de formation des régions de diffusion d'impureté dope lesdites première et deuxième régions de diffusion de source (36, 24) et lesdites première et deuxième régions de diffusion de drain (37, 27) desdits premier et deuxième transistors (60, 23) à un deuxième type semiconducteur avec un premier dosage, lesdits premier et deuxième types semiconducteurs étant des types semiconducteurs différents.

12. Procédé selon la revendication 11, caractérisé en ce qu'il est en outre prévu l'opération consistant à doper une partie (26, 29) de chacune des régions que forment ladite deuxième région de diffusion de source (24) et ladite deuxième région de diffusion de drain (27) dudit deuxième transistor (23) au deuxième type semiconducteur avec un deuxième dosage, le premier dosage étant inférieur au deuxième dosage.

13. Procédé selon la revendication 12, caractérisé en ce que lesdits premier et deuxième types semiconducteurs sont respectivement les semiconducteurs de type p et n, et lesdits premier et deuxième transistors (60, 23) sont des transistors à effet de champ du type à grille isolée à canal n.

14. Procédé selon l'une quelconque des revendications 8 à 13, caractérisé en ce que ledit premier transistor (60) forme une cellule de mémoire (3) d'un dispositif de mémoire à semiconducteur et ledit deuxième transistor (23) forme un circuit périphérique (4) du dispositif de mémoire à semiconducteur.

15. Procédé selon la revendication 14, caractérisé en ce que sont en outre prévues les opérations consistant à former un trou de contact (61) dans ladite première couche d'isolant (52B) et à former un condensateur empilé (6) sur ladite première couche d'isolant, ledit condensateur empilé ayant une électrode de stockage (19) qui établit un contact avec ladite première région de diffusion de drain (37) via ledit trou de contact afin de former la cellule de mémoire (3) du dispositif de mémoire à semiconducteur.

16. Procédé selon l'une quelconque des revendications 8 à 15, caractérisé en ce que lesdites première et deuxième couches d'isolant (52B) sont constituées en dioxyde de silicium.

17. Procédé selon la revendication 12, caractérisé en ce que ladite opération de dopage implante des ions d'impureté dans ladite deuxième région de diffusion de source (24) et ladite deuxième région de diffusion de drain (27) dudit deuxième transistor (23) en utilisant comme masque au moins ladite deuxième grille (31) ainsi que ladite première couche d'isolant (65, 66) et ladite couche d'isolation de paroi latérale (71, 72) se trouvant au niveau des parties parois latérales de ladite deuxième grille.
